Europäisches Patentamt

European Patent Office

Office européen des brevets

(19)

(11) Veröffentlichungsnummer: **0 144 955 B2**

(12)

# NEUE EUROPÄISCHE PATENTSCHRIFT

(45) Veröffentlichungstag der neuen Patentschrift:
29.05.91 Patentblatt 91/22

(51) Int. Cl.⁵: **H05K 7/18, F16S 3/02**

(21) Anmeldenummer: **84114687.1**

(22) Anmeldetag: **03.12.84**

(54) **Rahmengestell für einen Schaltschrank.**

(30) Priorität: **09.12.83 DE 3344598**

(43) Veröffentlichungstag der Anmeldung:
**19.06.85 Patentblatt 85/25**

(45) Bekanntmachung des Hinweises auf die
Patenterteilung:
**22.06.88 Patentblatt 88/25**

(45) Bekanntmachung des Hinweises auf die
Entscheidung über den Einspruch:
**29.05.91 Patentblatt 91/22**

(84) Benannte Vertragsstaaten:
**AT BE CH FR GB IT LI LU NL SE**

(56) Entgegenhaltungen:
DE-A- 1 753 038
DE-A- 1 962 561
DE-A- 2 654 239
DE-A- 2 654 590
DE-B- 1 183 158
DE-U- 7 832 909
FR-A- 1 290 354
FR-A- 2 420 233
GB-C- 1 512 899

(73) Patentinhaber: **Rittal-Werk Rudolf Loh GmbH
& Co. KG
Auf dem Stützelberg
W-6348 Herborn (DE)**

(72) Erfinder: **Debus, Jürgen
Am Ebersbach 50
W-6344 Dietzhölztal 1 (DE)**
Erfinder: **Zachrai, Jürgen
Am Hungersberg
W-6341 Dillenburg 8 (DE)**
Erfinder: **Koch, Hans-Georg
Sonnenstrasse 28
W-6344 Dietzhölztal 1 (DE)**
Erfinder: **Bütergerds, Helmut
Jahnstrasse 12
W-6345 Eschenburg 1 (DE)**

(74) Vertreter: **Vogel, Georg
Pat.-Ing. Georg Vogel Hermann-Essig-Strasse
35
W-7141 Schwieberdingen (DE)**

EP 0 144 955 B2

**Beschreibung**

Die Erfindung betrifft ein Rahmengestell für einen Schaltschrank, bestehend aus mindestens zwölf miteinander verbundenen Rahmenschenkeln desselben Hohlprofils, bei dem das als Vierkantprofil ausgebildete Hohlprofil mit Lochreihen versehen ist und mit zwei senkrecht zueinander stehenden Kantenseiten eine Kante bildet, bei dem der Kante abgekehrt am Hohlprofil zwei Profilschenkel angebracht sind, die jeweils parallel zu der zugeordneten Kantenseite ausgerichtet sind, und bei dem die Kanten aller Rahmenschenkel im Bezug auf den Innenraum des Rahmengestelles gleich angeordnet sind.

Ein Rahmengestell dieser Art ist z.B. durch die DE-A 26 54 239 bekannt. Bei diesem bekannten Rahmengestell sind die Kanten im Bezug auf den Innenraum alle nach außen gekehrt, so daß die beiden Kantenseiten in die Ebenen der aufeinanderstoßenden Seiten des Schaltschrankes ausgerichtet sind. Die Profilschenkel sind gegenüber den Kantenseiten zurückgesetzt und mit einer Lochreihe versehen.

Ein Hohlprofil dieser Art bietet wohl die Möglichkeit, die Profilschenkel als Anlagesteg für eine Tür die Seitenwände auszunutzen. Außerdem können die Profilschenkel auch zur Befestigung von Tragschienen ausgenützt werden. Für die Anbringung der Tragschienen ist jedoch stets nur eine Ausrichtung parallel zu einer der aufeinanderstoßenden Seiten des Schaltschrankes möglich. Außerdem erlaubt dieses bekannte Rahmengestell keine einfache, abgedichtete Aneinanderreihung derartiger Rahmengestelle. Der Vorteil dieses bekannten Rahmengestelles liegt allein in der Verwendung eines einheitlichen Hohlprofils für alle zwölf Rahmenschenkel des Rahmengestelles mit der Möglichkeit, die Tür, die Rückwand und die Seitenwände anzubringen.

Aus der FR-A 12 90 354 ist es bekannt, an Verbindungsschienen eines Schrankes Dichtungsstege abzukanten, die den dichten Anschluß der Tür oder der Rückwand an den Schrankkorpus ermöglichen.

Es ist Aufgabe der Erfindung, ein Rahmengestell der eingangs erwähnten Art zu schaffen, das unter Beibehaltung eines einheitlichen Hohlprofils die Anbringungsmöglichkeiten von Tragschienen und dgl. an allen Rahmenschenkeln des Rahmengestelles jeweils in Richtung beider aufeinanderstossender Seiten des Schaltschrankes zulässt und das nach allen Seiten hin mit Rahmengestellen erweiterbar ist und dabei in einfacher Weise eine eindeutige Abdichtung an den Stossstellen ermöglicht.

Diese Aufgabe wird nach der Erfindung dadurch gelöst, dass das Hohlprofil als Vierkantprofil ausgebildet ist, dass die Kanten aller miteinander verbundener Rahmenschenkel zum Innenraum des Rahmengestelles gerichtet sind, dass die Profilschenkel Verlängerungen der zugeordneten Kantenseiten sind, dass die Kantenseiten symmetrisch zur Kante mit gleichen Lochreihen versehen sind, dass die die Vorderseite und die Rückseite des Rahmengestelles bildenden Rahmenschenkel mit ihren abstehenden Profilschenkeln einen senkrecht zur Vorder- bzw. Rückseite stehenden, rahmenartigen Dichtungssteg bilden und dass die die vertikalen Seiten des Rahmengestelles bildenden Rahmenschenkel mit ihren abstehenden Profilschenkeln einen senkrecht zu den vertikalen Seiten stehenden rahmenartigen Anlagesteg bilden.

Die Verlagerung der Kanten auf die Innenseite des Rahmengestelles und die symmetrische Einbringung von Lochreihen in die aufeinanderstossenden Kantenseiten bringen an allen Rahmenschenkeln des Rahmengestelles jeweils eine Anbaumöglichkeit in zwei Richtungen, was den Einbau von Tragschienen, Schaltgeräten und dgl. wesentlich erleichtert. Die Profilschenkel der so ausgerichteten Rahmenschenkel wirken als Dichtungsstege und Anlagerahmen, so dass mit zugeordneten Dichtungselementen allseitig eine abgedichtete Aneinanderreihung von Rahmengestellen dieser Art möglich ist und auch die angebrachten Abschlusswände und Türen eindeutig abgedichtet werden können. Stossen Dichtungsstege aufeinander, werden H-förmige Dichtungselemente verwendet.

Als besonders vorteilhaft hat sich eine Ausgestaltung erwiesen, die dadurch gekennzeichnet ist, dass das Vierkantprofil eine im Querschnitt quadratische Aufnahme umschliesst und dass die Löcher der Lochreihen in den Kantenseiten quadratisch oder rechteckförmig und in einheitlicher Teilung eingebracht sind. Zur Erweiterung der Befestigungsmöglichkeiten kann nach einer weiteren Ausgestaltung noch vorgesehen sein, dass zwischen den quadratischen oder rechteckförmigen Löchern der Lochreihen um eine halbe Teilung versetzt Bohrungen angeordnet sind.

Als zweckmässig hat sich eine Ausgestaltung erwiesen, die dadurch gekennzeichnet ist, dass die Löcher der Lochreihen aller vertikaler Rahmenschenkel in gleichen horizontalen Ebenen angeordnet sind, dass die Löcher aller parallel zur Vorder- und Rückseite des Rahmengestelles verlaufender horizontaler Rahmenschenkel in gleichen vertikalen, parallel zur Vorder- und Rückseite verlaufender Ebenen angeordnet sind und dass die Löcher aller senkrecht zur Vorder- und Rückseite des Rahmengestelles verlaufender horizontaler Rahmenschenkel in gleichen vertikalen, senkrecht zur Vorder- und Rückseite verlaufender Ebenen angeordnet sind. Tragschienen, Querstreben und dgl. lassen sich dann ohne Schwierigkeiten horizontal und vertikal gerichtet in dem Rahmengestell anbringen.

Ist nach einer Ausgestaltung vorgesehen, dass der flache Profilschenkel des Vierkantprofils auf der dem Vierkantprofil zugekehrten Innenseite über einen Absatz in einen verdickten Endabschnitt übergeht und dass der Absatz dem Vierkantprofil zugekehrt eine in der Teilung der Lochreihe der Kantenseiten angeordnete rechteckige Verzahnung aufweist, bei der die Zahnlücken mit den quadratischen oder rechteckförmigen Löchern in den Kantenseiten des Vierkantprofils fluchten, dann lassen sich Beschlagteile und dgl. in stufig vorgegebenen Stellungen an diesem flachen Profilschenkel festlegen. Dabei ist vorzugsweise vorgesehen, dass die Beschlagteile an der Befestigungsfläche m einer Gegenverzahnung versehen sind, die mit der Verzahnung am dem flachen Profilschenkel des Vierkantprofils in Eingriff bringbar ist.

Die Verbindung der Rahmenschenkel zum Rahmengestell kann nach einer Ausgestaltung so ausgeführt sein, dass die Rahmenschenkel an den Ecken miteinander verschweisst sind. Die Verbindung kann jedoch auch dadurch noch versteift werden, dass die Rahmenschenkel an den Ecken mittels Eckverbinder miteinander verbunden sind, die mit Ansätzen in die Aufnahmen der aufeinander stossenden Rahmenschenkel eingeführt sind, und dass die Rahmenschenkel an den Ecken mit den Eckverbindern verschraubt und/oder verschweisst sind.

Das Rahmengestell lässt sich dadurch verwindungssicher machen, dass zusätzliche Querstreben mit mindestens zwei senkrecht zueinander stehenden Kantenseiten, die mit gleichen Lochreihen wie die Rahmenschenkel des Rahmengestelles versehen sind, einander gegenüberliegende horizontale oder vertikale Rahmenschenkel des Rahmengestelles miteinander verbinden.

Als Querstreben wird bevorzugt ein Profil verwendet, das eine quadratische Innenaufnahme aufweist, die der Aufnahme des Vierkantprofils der Rahmenschenkel des Rahmengestelles entspricht. Eine Seite des Profils weist einen durchgehenden Schlitz auf, durch den die Innenaufnahme zugänglich ist. Diese Querstreben können dann auch sogenannte Schiebemuttern aufnehmen und erlauben zusätzlich dazu eine weitere Befestigungsmöglichkeit in zwei Richtungen.

Die Verbindung zwischen einer Querstrebe und einem Rahmenschenkel des Rahmengestelles wird nach einer Ausgestaltung so ausgeführt, dass in die Innenaufnahme der Querstrebe eine quaderförmige Mutter einsteckbar ist, die mittels einer Kopfschraube an einem Rahmenschenkel des Rahmengestelles festlegbar ist.

Ist die Mutter so ausgebildet, dass die Seitenwände der Mutter mit Gewindeaufnahmen und die Stirnseiten mit auf die Löcher der Rahmenschenkel abgestimmten quadratischen oder rechteckförmigen Ansätzen versehen sind und dass eine Seite der Querstrebe mit Befestigungsbohrungen versehen ist, dann kann sie durch Verschraubung an der Querstrebe festgelegt werden. Das Einführen der Kopfschraube in ein quadratisches oder rechteckförmiges Loch eines Rahmenschenkels des Rahmengestelles wird dadurch erleichtert, dass der Kopf der Kopfschraube rechteckförmigen Querschnitt aufweist, wobei die kleinere Abmessung der Abmessung der quadratischen Löcher in den Rahmenschenkeln des Rahmengestelles entspricht, während die grössere Abmessung geringfügig grösser ist und ein schräges Einführen des Kopfes in ein derartiges Loch zulässt. Nach dem Ausrichten der Kopfschraube hält der Kopf die Kopfschraube am Rahmenschenkel des Rahmengestelles fest. Das Festziehen der am Rahmenschenkel des Rahmengestelles festgelegten Mutter wird dadurch erleichtert, dass die Kopfschraube am Ende des Gewindeteiles mit einer stirnseitigen Werkzeugaufnahme versehen ist, da darüber die eingeführte Kopfschraube gedreht oder festgehalten werden kann.

Nach einer weiteren Ausgestaltung kann jedes quadratische oder rechteckförmige Loch der Rahmenschenkel des Rahmengestelles dadurch zur Befestigung eines Teiles ausgenützt werden, dass in die quadratischen oder rechteckförmigen Löcher der Kantenseiten der Rahmenschenkel und der Querstreben von der Innenseite her Muttern mit einem quadratischen oder rechteckförmigen Steckansatz an dem zugekehrten Ende der Gewindeaufnahme unverdrehbar einsetzbar sind, wobei die Muttern mit einer Handhabe versehen sind, die durch das fluchtende Loch der jeweils anderen Kantenseite ragt. Ist vorgesehen, dass die Handhabe an einer Sollbruchstelle von der Mutter abtrennbar ist, dann kann nach der Herstellung der Verbindung die Handhabe abgebrochen werden, so dass kein Teil der Mutter mehr aus dem Vierkantprofil herausragt.

Bei abgebrochener Handhabe kann die Mutter auch als Schiebemutter für einen Profilabschnitt mit T-förmiger Nut oder Aufnahme verwendet werden. Für die Anbringung von Beschlagteilen und dgl., sowie für die Aneinanderreihung der Rahmengestelle ist eine Ausgestaltung von Vorteil, die dadurch gekennzeichnet ist, dass die den Kantenseiten des Vierkantprofils gegenüberliegenden Seiten mit zusätzlichen Bohrungen versehen sind, die mit zugeordneten quadratischen oder rechteckförmigen Löchern der Kantenseiten fluchten.

Die seitliche Aneinanderreihbarkeit der Rahmengestelle wird nach einer Ausgestaltung dadurch verbessert, dass ein Profilschenkel der Rahmenschenkel am freien Ende einen zum Vierkantprofil hin eingebogenen Endabschnitt aufweist, dass die die vertikalen Seiten des Rahmengestelles bildenden Rahmenschenkel mit diesen Endabschnitten der abgewinkelten Profilschenkel die Anlagestege zu Anlagerahmen erweitern, deren Anlageflächen parallel zu den vertikalen Seiten des Rahmengestelles verlaufen und dass die Endabschnitte der abgewinkelten Profilschenkel mit schlitzförmigen Ausnehmungen versehen sind, die mit den Befestigungsbohrungen der zugekehrten, parallelen Seiten der Vierkantprofile fluchten.

Die Herstellung der Rahmenschenkel des Rahmengestelles kann durch Ablängen eines entsprechenden Strangpressprofil oder Walzprofils erfolgen.

Bei einem Walzprofil hat sich eine Ausgestaltung bewährt, die dadurch gekennzeichnet ist, dass der flache Profilschenkel und der abgewinkelte Profilschenkel des Vierkantprofils doppellagig ausgebildet sind und dass am flachen Profilschenkel die Verdickung durch einen auf die innere Lage umgebogenen Endabschnitt der aussenliegenden Lage gebildet ist, wobei am umgebogenen Endabschnitt die Verzahnung mit den Zahnlücken ausgestanzt ist. Dabei kann die Verzahnung schon vor dem Walzvorgang ausgestanzt werden.

Ist vorgesehen, dass alle Ecken und Kanten des Vierkantprofils abgerundet sind, dann werden alle scharfen Kanten, die eine Gefahrenstelle für Verletzungen bilden, vermieden.

Ist nach einer Weiterbildung vorgesehen, dass die Abschlusswände und die Türen mit einem Stülprand versehen sind, der den rahmenartigen Dichtungssteg an der Vorder- oder Rückseite und den Anlagerahmen an den vertikalen Seiten des Rahmengestelles umschliesst und dass die Abschlusswände und die Türen im Bereich der Anlage zu dem Dichtungssteg und dem Anlagerahmen mit Dichtungselementen versehen sind, dann können das Rahmengestell selbst und aneinandergereihte Rahmengestelle allseitig abgedichtet verschlossen werden.

Die Erfindung wird anhand eines in den Zeichnungen dargestellen Ausführungsbeispiels näher erläutert. Es zeigt :

Fig. 1 den Querschnitt durch einen Rahmenschenkel des Rahmengestelles,

Fig. 2 die Ansicht auf den Rahmenschenkel nach Fig. 1 in Richtung II,

Fig. 3 die Ansicht auf den Rahmenschenkel nach Fig. 1 in Richtung III,

Fig. 4 die Ansicht auf den Rahmenschenkel nach Fig. 1 in Richtung IV,

Fig. 5 in perspektivischer Ansicht den unteren Teil eines Rahmengestelles nach der Erfindung,

Fig. 6 in perspektivischer Ansicht den oberen Teil des Rahmengestelles,

Fig. 7 den Einsatz von Muttern in die quadratischen Löcher eines Rahmenschenkels,

Fig. 8 die Mutter nach Fig. 7 in Draufsicht,

Fig. 9 die Mutter nach Fig. 7 in Seitenansicht,

Fig. 10 in perspektivischer Ansicht die Kopfschraube,

Fig. 11 in perspektivischer Ansicht die quaderförmige Mutter,

Fig. 12 einen Abschnitt einer Querstrebe, die mit der Kopfschraube nach Fig. 10 und der Mutter nach Fig. 11 an einem Rahmenschenkel des Rahmengestelles befestigt werden kann,

Fig. 13 einen Schnitt, der die dichte Anbringung einer Tür und einer Seitenwand an einem vertikalen Rahmenschenkel des Rahmengestelles erkennen lässt und

Fig. 14 einen Schnitt, der die dichte Aneinanderreihung von zwei Rahmengestellen, die mit Türen verschliessbar sind, erkennen lässt.

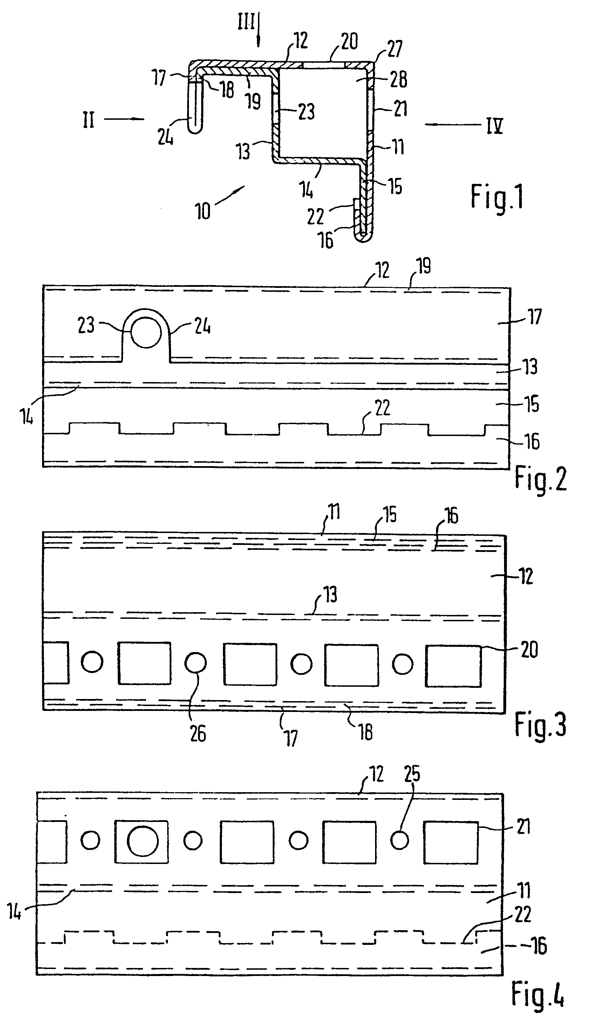

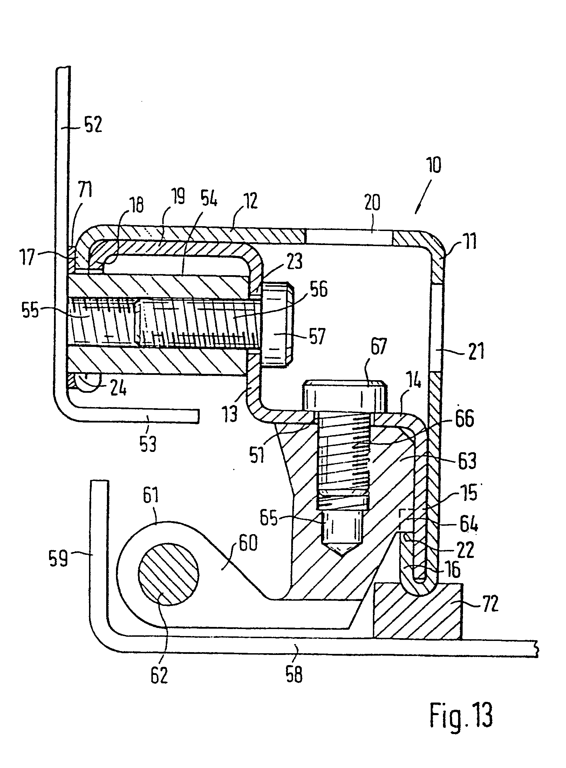

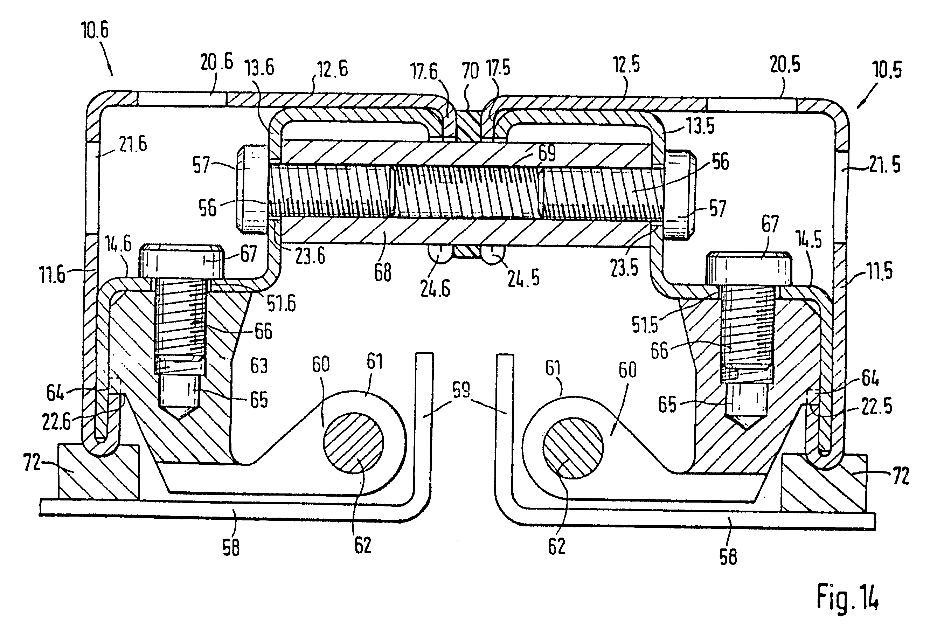

Der in Fig. 1 gezeigte Querschnitt des Hohlprofils lässt erkennen, dass sich an ein Vierkantprofil 10 mit quadratischer Aufnahme 28 an die Kantenseiten 11 und 12 bündig Profilschenkel anschliessen. Der eine flache Profilschenkel ist einfach die Verlängerung der Kantenseite 11, während der andere Profilschenkel die Verlängerung der Kantenseite 12 des Vierkantprofils 10 ist, am Ende aber rechtwinklig abgebogen den Endabschnitt 17 trägt, der parallel zur Seite 13 des Vierkantprofils verläuft. Bei dem Ausführungsbeispiel ist das Hohlprofil als Walzprofil hergestellt, so dass die Profilschenkel jeweils deoppellagig sind, wie die Abschnitte 15, 18 und 19 zeigen. Die Kantenseite 11 wird dabei mit dem Endabschnitt 16 um den Abschnitt 15 gebogen, so dass am Ende des flachen Profilschenkels die Verdickung entsteht. Dieser Endabschnitt 16 ist so ausgestanzt, dass an der Endkante die Verzahnung mit den Zahnlücken 22 entsteht, die mit den rechteckförmigen Löchern 20 und 21 in den Kantenseiten 11 und 12 fluchten, wie die Ansichten nach Fig. 2 bis 4 erkennen lassen. Die Löcher 20 und 21 sind in gleicher Teilung un in gleichem Abstand zu der Kante 27 angeordnet, an der die Kantenseiten 11 und 12 zusammenstossen. Um eine halbe Teilung versetzt tragen die Kantenseiten 11 und 12 auch noch Bohrungen 25 und 26, so dass die Anbringungsmöglichkeiten an dem Hohlprofil erweitert sind. In dem abgewinkelten Profilschenkel sind in dem Endabschnitt 17 und dem Abschnitt 18 schlitzförmige Ausnehmungen 24 eingebracht, die mit Bohrungen 23 in der Seite 13 und Löchern 21 in der Kantenseite 11 des Vierkantprofils 10 fluchten. In der gleichen Weise kann die Seite 14 des Vierkantprofils 10 Bohrungen 51 tragen (Fig. 13 und 14), die mit Löchern 20 in der Kantenseite 12 fluchten, um Bauteile und dgl. an der Seite 14 des Vierkantprofils 10 anbringen zu können.

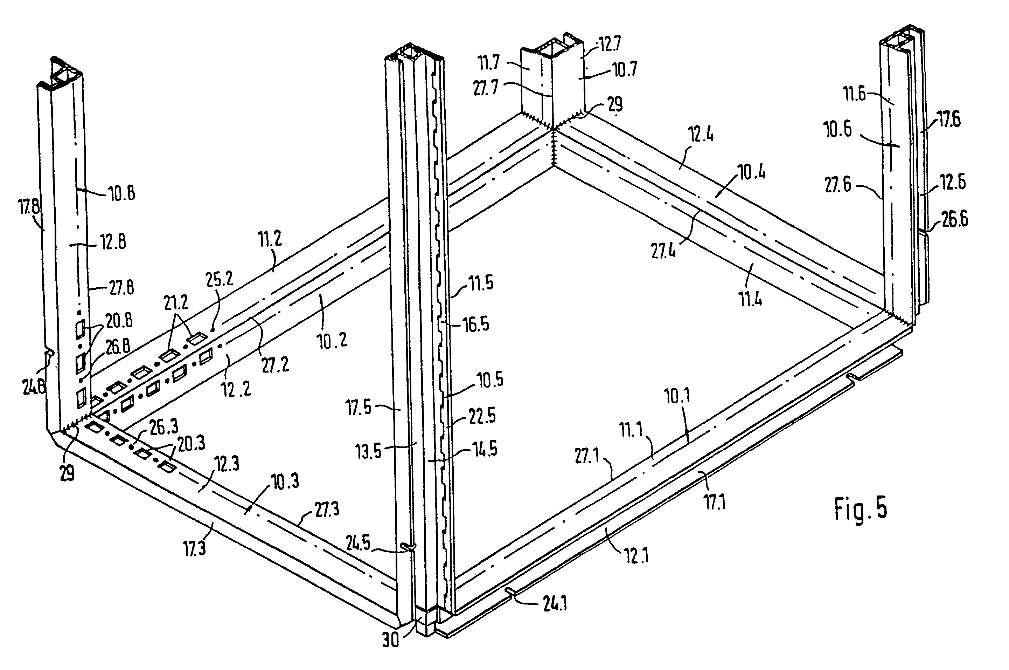

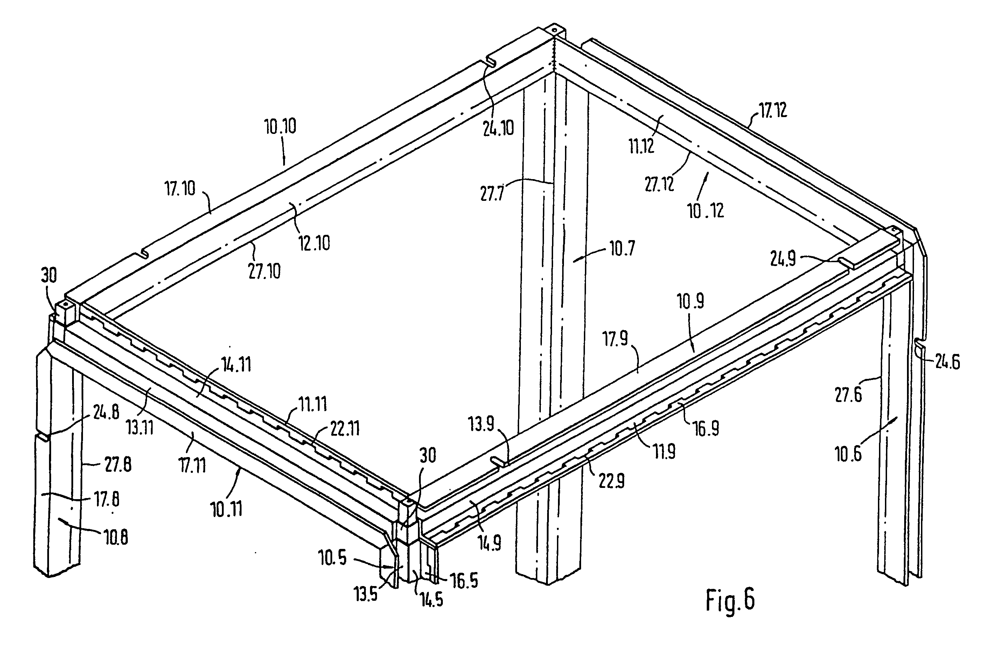

Nach der Erfindung ist nicht nur der Querschnitt des Hohlprofils von entscheidender Bedeutung, es ist auch wichtig, wie die zwölf aus dem Hohlprofil abgelängten Rahmenschenkel 10.1 bis 10.12 zum Rahmengestell miteinander verbunden werden. Das zusammengebaute Rahmengestell ist aus den Fig. 5 und 6 zu ersehen. Als erstes entscheidendes Merkmal ist die Ausrichtung aller Kanten 27.1 bis 27.12 der Rahmenschenkel 10.1 bis 10.12 auf die Innenseite des Rahmengestelles, so dass die Kanten 27.1 bis 27.12 auf einer Art « Kantengestell » liegen. Die Rahmenschenkel 10.1, 10.5, 10.6 und 10.9 bilden den vorderen Rahmen des Rahmengestelles. Die Kantenseiten 11.1, 11.5, 11.6 und 11.9 mit den flachen Pro-

filschenkeln sind zur Vorderseite hin gerichtet und einander zugekehrt, so dass sie einen rahmenartigen, senkrecht zur Vorderseite stehenden Dichtungssteg bilden. Die Kantenseiten 12.1, 12.5, 12.6 und 12.9 sind jeweils zur Rahmenaussenseite gekehrt und stehen mit ihren Endabschnitten 17.1, 17.5, 17.6 und 17.9 jeweils parallel zu der an dem Rahmen anschliessenden Seite des Rahmengestelles.

In gleicher Weise bilden die Rahmenschenkel 10.2, 10.7, 10.8 und 10.10 den hinteren Rahmen des Rahmengestelles. Auch hier bilden die Kantenseiten 11.2, 11.7, 11.8 und 11.10 einen senkrecht zur Rückseite stehenden, rahmenartigen Dichtungssteg, während die Endabschnitte 17.2, 17.7, 17.8 und 17.10 wieder parallel zu den anschliessenden Seiten stehen.

Die Rahmenschenkel 10.3 und 10.4 verbinden den vorderen und hinteren Rahmen an der Unterseite des Rahmengestelles und die Rahmenschenkel 10.10 und 10.12 an der Oberseite. Der Rahmenschenkel 10.3 ist mit seiner Kante 27.3 auf die Kanten 27.1 und 27.5 der Rahmenschenkel 10.1 und 10.5, sowie die Kanten 27.2 und 27.8 der Rahmenschenkel 10.2 und 10.8 ausgerichtet. Der Rahmenschenkel 10.4 stösst mit seiner Kante 27.4 auf die Kanten 27.1, 27.6, 27.2 und 27.7 der Rahmenschenkel 10.1, 10.6, 10.2 und 10.7 und vervollständigt den Kantenrahmen an der Unterseite des Rahmengestelles. Dabei sind an den Rahmenschenkeln 10.3 und 10.4 diesmal die Kantenseiten 12.3 und 12.4 nach oben gerichtet, damit ihre Endabschnitte 17.3 und 17.4 die Anlagerahmen an den vertikalen Seiten des Rahmengestelles vervollständigen können. Die Endabschnitte 17.3, 17.5, 17.8 und 17.11 der Rahmenschenkel 10.3, 10.5, 10.8 und 10.11 bilden den Anlagerahmen an der rechten Seite des Rahmengestelles, da auch die Rahmenschenkel 10.11 und 10.12 an der Oberseite des Rahmengestelles so ausgerichtet sind, dass ihre Kantenseiten 12.11 und 12.12 an die Kantenseiten 12.5 und 12.8 bzw. 12.6 und 12.7 anschliessen und ihre Kantenseiten 11.11 und 11.12 senkrecht nach oben stehen.

An der rechten Seite des Rahmengestelles bilden die Endabschnitte 17.4, 17.6, 17.7 und 17.12 der Rahmenschenkel 10.4, 10.6, 10.7 und 10.12 einen Anlagerahmen, der parallel zu der rechten Seite des Rahmengestelles steht.

Bei dieser Anordnung der Rahmenschenkel ist an jeder Kante des Rahmengestelles, bezogen auf das Kantengestell, jeweils eine Anbaumöglichkeit in den Richtungen der an der Kante aufeinanderstossenden Seiten des Rahmengestelles gegeben, wie die Löcher 20 und 21 in den an den Kanten 27 zusammenstossenden Kantenseiten 11 und 12 zeigen.

Die Verzahnung mit den Zahnlücken 22 am Endabschnitt 16 der flachen Profilschenkel ist jeweils an den Aussenseiten des rahmenartigen Dichtungssteges und zwar sowohl an der Vorder-, als auch an der Rückseite des Rahmengestelles, was besonders für die Anbringung von Türen von Bedeutung ist, wie noch gezeigt wird. An den Ecken des Rahmengestelles können die drei aufeinanderstossenden Rahmenschenkel verschweisst sein, wie die Schweissnähte 29 zeigen. Es können jedoch auch an sich bekannte Eckverbinder 40 verwendet werden, die mit ihren Ansätzen in die Aufnahmen 28 der Vierkantprofile 10 eingesteckt sind. Diese Eckverbinder 30 können mit den Rahmenschenkeln verschraubt und/oder verschweisst sein.

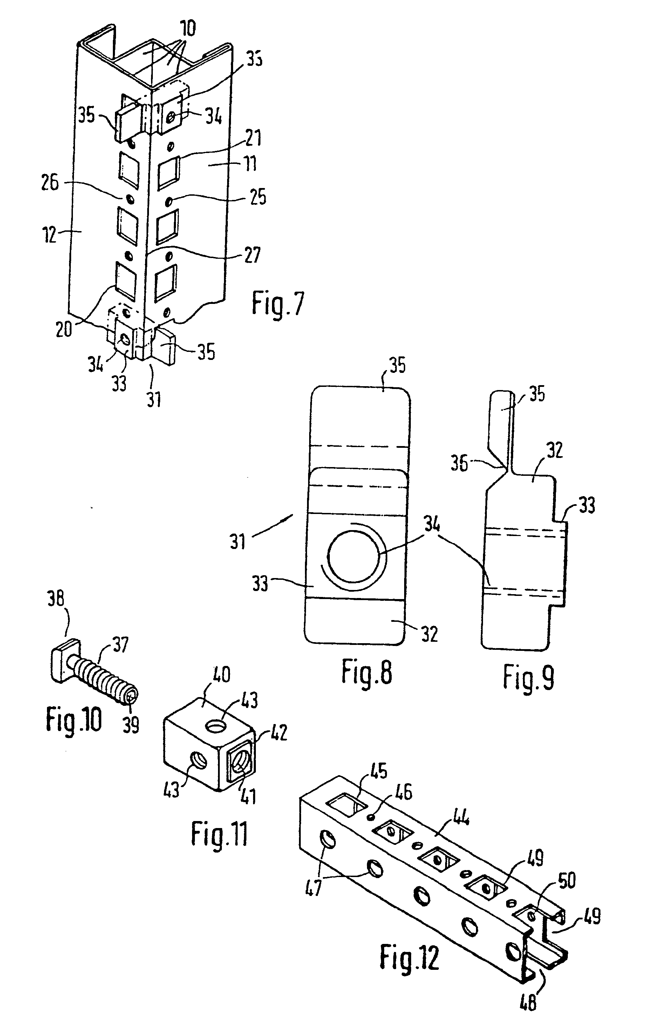

Die Fig. 7 zeigt, wie ein rechteckförmiges Loch 20 oder 21, das mit der grösseren Abmessung in Längsrichtung des Rahmenschenkels gerichtet ist, in den Kantenseiten 11 und 12 eines Rahmenschenkels für die Befestigung eines Bauteiles ausgenützt werden kann. Dazu wird eine Mutter 31 nach Fig. 8 und 9 verwendet. Diese Muttern 31 haben in dem Block 32 die Gewindebohrung 34, die an einer Seite in dem rechteckförmigen Steckansatz 33 endet. An der gegenüberliegenden Seite des Blockes 32 ist die Handhabe 35 angeformt, die an der Sollbruchstelle 36 abgebrochen werden kann. Mit der Handhabe 35 kann die Mutter 31 durch ein Loch 21 in der Kantenseite 11 eingeführt und mit dem Steckansatz 33 in einem Loch 20 der Kantenseite 12 unverdrehbar gehalten werden, so dass in die im Loch 20 zugängliche Gewindeaufnahme 34 eine Befestigungsschraube eingeschraubt werden kann. Ist die Verbindung hergestellt, dann kann die Handhabe 35 abgebrochen werden, so dass kein Teil der Mutter 31 mehr aus dem Vierkantprofil 10 vorsteht. In gleicher Weise kann die Mutter 31 auch über ein Loch 20 der Kantenseite 12 eingeführt und in einem Loch 21 der Kantenseite 11 unverdrehbar festgelegt werden. Dabei ist nur wichtig, dass die Handhabe 35 in dem richtigen Abstand zum Steckansatz 33 steht, der den Abstand der Löcher 20 und 21 von der Kante 27 berücksichtigt.

Ist die Handhabe 35 abgebrochen, dann kann die Mutter 31 auch als Schiebemutter verwendet werden, wenn sie in eine entsprechende T-Nut einer Profilschiene eingeführt ist. Der Steckansatz 33 ist dabei unverdrehbar in dem Schlitz der Profilschiene geführt, der Zugang zur hinterschnittenen Aufnahme der T-Nut verschafft. So kann die Mutter 31 z.B. als Schiebemutter in dem Profil nach Fig. 12 verwendet werden. Aus diesem Profil können Querstreben 44 abgelängt werden, die zwei vertikale oder zwei horizontale Rahmenschenkel miteinander verbinden. Die Querstreben 44 können auch einen L-förmigen, U-förmigen Querschnitt aufweisen oder als geschlossenes Vierkantprofil ausgebildet sein. Wesentlich ist nur, dass sie wie die Rahmenschenkel 10.1 bis 10.12 zwei senkrecht zueinander stehende Kantenseiten haben, in denen in gleicher Verteilung und Anordnung zur Kante Lochreihen aus rechteckförmigen Löchern 45 und 49, sowie Bohrungen 46 und 50 eingebracht sind. Die Innenaufnahme der Querstrebe 44 entspricht im Querschnitt der Aufnahme 28 des Vierkantprofils 10. Die anderen Seiten der Querstrebe 44 sind mit Bohrungen 47 und mit dem Schlitz 48 versehen. Die Löcher 20 und 21 und der Steckansatz 33 können jedoch auch quadratischen Querschnitt haben.

In die Innenaufnahme der Querstrebe 44 nach Fig. 12 ist die quaderförmige Mutter 40 mit der durchgehenden Gewindeaufnahme 41 nach Fig. 11 einsteckbar. Dabei kann die Mutter 40 mittels Schrauben an der Querstrebe 44 festgeschraubt werden. Dazu sind in den Seiten der Mutter die Gewindeaufnahmen 43 eingebracht.

Die Befestigungsschraube kann durch die Bohrung 47 der Querstrebe 44 eingeführt und in eine Gewindeaufnahme 43 der eingesteckten Mutter 40 eingeschraubt werden. Die Mutter 40 ist aber vorher mittels der Kopfschraube 37 nach Fig. 10 an einem Rahmenschenkel des Rahmengestelles festgelegt. Dazu wird der rechteckförmige Kopf 38 der Kopfschraube 37 vorher schräg in ein quadratisches oder rechteckförmiges Loch 20 oder 21 des Rahmenschenkels eingeführt. Zu diesem Zweck entspricht eine Abmessung des Kopfes 38 der Abmessung des Loches 20 bzw. 21. Die andere Abmessung ist etwas grösser, so dass der Kopf 38 in Schrägstellung der Kopfschraube 37 in das Loch 20 oder 21 eingeführt werden kann, nach der Ausrichtung aber sich hinter das Loch 20 oder 21 legt. Die Kopfschraube 37 kann daher nicht mehr aus dem Loch 20 oder 21 gezogen werden. Auf die Kopfschraube 37 ist die Mutter 40 bereits so weit aufgeschraubt, dass sie nur noch festgezogen werden muss. Die Kopfschraube 37 hat die stirnseitige Werkzeugaufnahme 39, damit sie unverdrehbar festgehalten werden kann, solange die Mutter 40 noch frei drehbar ist. Wird der quadratische Ansatz 42 der Mutter 40 jedoch in das Loch 20 oder 21 eingeführt, dann kann die Mutter 40 nicht mehr verdreht werden. Dann wird die Kopfschraube 37 gedreht, bis die Verbindung endgültig hergestellt ist. Die Mutter 40 kann auch sofort in dem Loch 20 oder 21 unverdrehbar festgehalten werden. Dann wird nur durch Drehen der in das Loch 20 der 21 eingeführten Kopfschraube 37 die Verbindung zwischen der Mutter 40 und dem Rahmenschenkel hergestellt.

Die so befestigten Querstreben 44 können mit ihrer Kante auf den Kantenrahmen des Rahmengestelles ausgerichtet an den Rahmenschenkeln befestigt werden. Dabei lassen die Löcher in den beiden Kantenflächen wieder eine Befestigungsmöglichkeit in zwei Richtungen zu, z.B. in der Ebene der zugeordneten Seite des Rahmengestelles und senkrecht dazu.

Anhand des Schnittes nach Fig. 13 wird gezeigt, wie eine Tür 58 an einem vertikalen Rahmenschenkel angelenkt werden kann. Dazu wird ein Scharnierteil 60 verwendet, das mittels der Schraube 66 an der Seite 14 des Vierkantprofils 10 befestigt ist. Das Scharnierteil 60 hat dabei einen Befestigungsblock 63 mit der Gewindeaufnahme 65, in die die Schraube 66 eingeschraubt ist. Die Schraube 66 mit dem Kopf 67 wird über ein Loch 20 der Kantenseite 12 eingeführt und durch die Bohrung 51 der Seite 14 hindurch in die Gewindeaufnahme 65 des Befestigungsblokkes 63 eingeschraubt. Die dem Abschnitt 15 des Rahmenschenkels zugekehrte Befestigungsfläche des Befestigungsblockes 63 trägt die Gegenverzahnung 64, die in die Verzahnung des Endabschnittes 16 mit den Zahnlücken 22 eingreift. Der Befestigungsblock 63 kann daher in vorgegebenen Stellungen an dem flachen Profilschenkel des Rahmenprofils befestigt werden. Das Lagerauge 61 des Scharnierteils nimmt den Lagerbolzen 62 auf, der auf der Innenseite der mit dem Stülprand 59 versehenen Tür 58 befestigt ist. Auf der Innenseite der Tür 58 ist ein flaches Dichtungselement 72 befestigt, das wie der flache Profilschenkel verläuft und so zwischen dem Rahmenschenkel und der Tür 58 eine eindeutige Abdichtung bringt. Das Dichtungselement 72 bildet einen Rahmen, der dem rahmenartigen Dichtungssteg an der Vorderseite des Rahmengestelles entspricht, der durch die abstehenden flachen Profilschenkel des vorderen Rahmens des Rahmengestelles gebildet wird. In gleicher Weise kann auch die Rückseite des Rahmengestelles mit einer Tür verschlossen werden.

Wie die Fig. 13 noch zeigt, kann die Seitenwand 52 mit ihrem Stülprand 53 den Anlagerahmen umgreifen, der durch die Endabschnitte 17 der Rahmenschenkel gebildet wird. Auf der Innenseite der Seitenwand 52 sind Gewindehülsen 54 angebracht, in deren Gewindeaufnahmen 55 Schrauben 56 eingeschraubt werden. Die Schraube 56 mit dem Kopf 57 wird dabei über ein Loch 21 der Kantenseite 11 eingeführt und durch die Bohrung 23 in der Seite 13 hindurch in die Gewindeaufnahme 55 der Gewindehülse 54 eingeschraubt. Das Dichtungselement 71 dichtet die Verbindung zwischen de Seitenwand 52 und dem Anlagerahmen ab.

In gleicher Weise kann die Rückwand an der Seite 14 des Rahmenschenkels befestigt werden. Dabei trägt die Rückwand gleiche Gewindehülsen, da der flache Profilschenkel und der abgewinkelte Profilschenkel die zugeordneten Kantenseiten 11 und 12 um dasselbe Mass verbreitern.

In der Fig. 14 sind die beiden vertikalen Rahmenschenkel 10.6 und 10.5 von zwei seitlich aneinandergereihten Rahmengestellen gezeigt, die mit ihren Endabschnitten 17.5 und 17.6 Bestandteil zweier gleicher Anlagerahmen bilden. Das Dichtungselement 70 folgt diesen Anlagerahmen und dichtet die Stossstelle ab. Eine Gewindehülse 68 mit Gewindeaufnahme 69 wird zwischen den Seiten 13.5 und 13.6 der Rahmenschenkel 10.5 und 10.6 angeordnet. Zwei Schrauben 56 stellen die Verbindung her, wobei die eine Schraube 56 mit Kopf 57 durch ein Loch 21.5 der Kantenseite 11.5 des Rahmenschenkels 10.5 eingeführt und durch die Bohrung 23.5 in der Seite 13.5 hindurch in die Gewindeaufnahme 69 der Gewindehülse 68 eingeschraubt wird. Die andere Schraube 56 mit Kopf 57 wird durch ein Loch 21.6 in der Kantenseite 11.6 des Rahmenschenkels 10.6 eingeführt und durch die Bohrung 23.6 der Seite 13.6 hindurch in die Gewindeaufnahme 69 der Gewindehülse 68 eingeschraubt. Die Bohrungen 23.5 und 23.6 fluchten mit den Löchern 21.5 und 21.6 und den Ausnehmungen 24.5 und 24.6 in den Endabschnitten 17.5 und 17.6 der abgewinkelten Profilschenkel. Über die Länge der Rahmenschenkel 10.5 und 10.6 sind mindestens zwei solche Verbindungen vorgesehen und auch die einander zugekehrten Rahmenschenkel auf der Rückseite der Rahmengestelle werden in gleicher Weise miteinander verbunden und abgedichtet. An den Seiten 14 der Rahmenschenkel 10.5 und 10.6 können zwei Türen 58 angelenkt werden, wobei die am Rahmenschenkel 10.5 angelenkte Tür 58 an der linken Kante und die an dem Rahmenschenkel 10.6 angelenkte Tür 58 an der rechten Kante angeschlagen ist. Die Bohrungen 51.5 und 51.6 in den Seiten 14.5 und 14.6 nehmen dabei die Schrauben 66 zur Befestigung der Scharnierteile 60 auf. Im übrigen ist die Anlenkung der Türen 58 wie in Fig. 13. Die Gegenverzahnungen 64 der Scharnierteile 60, die gleich gestaltet für links und rechts angeschlagene Türen 58 verwendbar sind, greifen in die Zahnlücken 22.5 und 22.6 der Verzahnungen der Endabschnitte der flachen Profilschenkel.

**Ansprüche**

1. Rahmengestell für einen Schaltschrank, bestehend aus mindestens zwölf miteinander verbundenen Rahmenschenkeln desselben Hohlprofils, bei dem das als Vierkantprofil ausgebildete Hohlprofil mit Lochreihen versehen ist und mit zwei senkrecht zueinander stehenden Kantenseiten eine Kante bildet, bei dem der Kante abgekehrt am Hohlprofil zwei Profilschenkel angebracht sind, die jeweils parallel zu der zugeordneten Kantenseite ausgerichtet sind, und bei dem die Kanten aller Rahmenschenkel im Bezug auf den Innenraum des Rahmengestelles gleich angeordnet sind, gekennzeichnet durch die Merkmalskombination,
daß die Kanten (27.1 bis 27.12) aller miteinander verbundenen Rahmenschenkel (10.1 bis 10.12) zum Innenraum des Rahmengestelles gerichtet sind,
daß die Profilschenkel Verlängerungen der zugeordneten Kantenseiten (11, 12) sind,
daß die Kantenseiten (11, 12) symmetrisch zur Kante (27) mit gleichen Lochreihen versehen sind,
daß die die Vorderseite und die Rückseite des Rahmengestelles bildenden Rahmenschenkel (10.1, 10.5, 10.6, 10.9 und 10.2, 10.7, 10.8, 10.10) mit ihren abstehenden Profilschenkeln einen senkrecht zur Vorder- bzw. Rückseite stehenden, rahmenartigen Dichtungssteg bilden und
daß die die vertikalen Seiten des Rahmengestelles bildenden Rahmenschenkel (10.3, 10.5, 10.8, 10.11 und 10.4, 10.6, 10.7, 10.12) mit ihren abstehenden Profilschenkeln einen senkrecht zu den vertikalen Seiten stehenden rahmenartigen Anlagesteg bilden.

2. Rahmengestell nach Anspruch 1, dadurch gekennzeichnet, dass das Vierkantprofil (10) eine im Querschnitt quadratische Aufnahme (28) umschliesst.

3. Rahmengestell nach Anspruch 1 oder 2, dadurch gekennzeichnet, dass die Löcher (20, 21) der Lochreihen in den Kantenseiten (11, 12) quadratisch oder rechteckförmig und in einheitlicher Teilung eingebracht sind.

4. Rahmengestell nach Anspruch 3, dadurch gekennzeichnet, dass zwischen den quadratischen oder rechteckförmigen Löchern (20, 21) der Lochreihen um eine halbe Teilung versetzt Bohrungen (25, 26) angeordnet sind.

5. Rahmengestell nach einem der Ansprüche 1 bis 4, dadurch gekennzeichnet, dass die Löcher (20, 21, 25, 26) der Lochreihen aller vertikaler Rahmenschenkel (10.5, 10.6, 10.7, 10.8) in gleichen horizontalen Ebenen angeordnet sind, dass die Löcher (20, 21, 25, 26) aller parallel zur Vorder- und Rückseite des Rahmengestelles verlaufender horizontaler Rahmenschenkel (10.1, 10.2, 10.9, 10.10) in gleichen vertikalen, parallel zur Vorder- und Rückseite verlaufender Ebenen angeordnet sind und dass die Löcher (20, 21, 25, 26) aller senkrecht zur Vorder- und Rückseite des Rahmengestelles verlaufender horizontaler Rahmenschenkel (10.3, 10.4, 10.11, 10.12) in gleichen vertikalen, senkrecht zur Vorder- und Rückseite verlaufender Ebenen angeordnet sind.

6. Rahmengestelle nach einem der Ansprüche 1 bis 5, dadurch gekennzeichnet, dass der flache Profilschenkel des Vierkantprofils (10) auf der dem Vierkantprofil (10) zugekehrten Innenseite über einen Absatz in einen verdickten Endabschnitt (16) übergeht und dass der Absatz dem Vierkantprofil (10) zugekehrt eine in der Teilung der Lochreihe der Kantenseiten (11, 12) angeordnete rechteckige Verzahnung aufweist, bei der die Zahnlücken (22) mit den quadratischen Löchern (20, 21) in den Kantenseiten (11, 12) des Vierkantprofils (10) fluchten.

7. Rahmengestell nach einem der Ansprüche 1 bis 6, dadurch gekennzeichnet, dass die Rahmenschenkel (10.1 bis 10.12) an den Ecken miteinander verschweisst (29) sind.

8. Rahmengestell nach einem der Ansprüche 1 bis 6, dadurch gekennzeichnet, dass die Rahmenschenkel (10.1 bis 10.12) an den Ecken mittels Eckverbinder (30) miteinander verbunden sind, die mit Ansätzen in die Aufnahmen (28) der aufeinander stossenden Rahmenschenkel (z.B. 10.1, 10.3, 10.5) eingeführt sind.

9. Rahmengestell nach Anspruch 8, dadurch gekennzeichnet, dass die Rahmenschenkel (10.1 bis 10.12) an den Ecken mit den Eckverbindern (30) verschraubt und/oder verschweisst sind.

10. Rahmengestell nach einem der Ansprüche 1 bis 9, dadurch gekennzeichnet, dass zusätzliche Querstreben (44) mit mindestens zwei senkrecht zueinander stehenden Kantenseiten, die mit gleichen Lochreihen wie die Rahmenschenkel (10.1 bis 10.12) des Rahmengestelles versehen sind, einander gegenüberliegende horizontale oder vertikale Rahmenschenkel (10.1, 10.2 oder 10.5, 10.8) des Rahmengestelles miteinander verbinden.

11. Rahmengestell nach Anspruch 10, dadurch gekennzeichnet, dass die Querstreben (44) eine quadratische Innenaufnahme aufweisen, die der Aufnahme (28) des Vierkantprofils (10) entspricht und dass die Innenaufnahme über einen durchgehenden Schlitz (48) in einer Seite der Querstrebe (44) zugänglich ist.

12. Rahmengestell nach Anspruch 10 und 11, dadurch gekennzeichnet, dass in die Innenaufnahme de Querstrebe (44) eine quaderförmige Mutter (40) einsteckbar ist, die mittels einer Kopfschraube (37) an einem Rahmenschenkel (10.1 bis 10.12) des Rahmengestelles festlegbar ist.

13. Rahmengestell nach Anspruch 12, dadurch gekennzeichnet, dass die Seitenwände der Mutter (40) mit Gewindeaufnahmen (43) und die Stirnseiten mit auf die Löcher (20, 21) der Rahmenschenkel (10.1 bis 10.2) abgestimmten quadratischen oder rechteckförmigen Ansätzen (42) versehen sind und dass eine Seite der Querstrebe (44) mit Befestigungsbohrungen (47) versehen ist.

14. Rahmengestell nach Anspruch 12, dadurch gekennzeichnet, dass der Kopf (38) der Kopfschraube (37) rechteckförmigen Querschnitt aufweist, wobei die kleinere Abmessung der Abmessung der quadratischen Löcher (20, 21) in den Rahmenschenkeln (10.1 bis 10.12) des Rahmengestelles entspricht, während die grössere Abmessung geringfügig grösser ist und ein schräges Einführen des Kopfes (38) in ein derartiges Loch (20, 21) zulässt.

15. Rahmengestell nach einem der Ansprüche 12 bis 14, dadurch gekennzeichnet, dass die Kopfschraube (39) am Ende des Gewindeteils mit einer stirnseitigen Werkzeugaufnahme (39) versehen ist.

16. Rahmengestell nach einem der Ansprüche 1 bis 15, dadurch gekennzeichnet, dass in die quadratischen oder rechteckförmigen Löcher (20, 21, 45, 49) der Kantenseiten (11, 12) der Rahmenschenkel (10.1 bis 10.12) und der Querstreben (44) von der Innenseite her Muttern (31) mit einem quadratischen oder rechteckförmigen Steckansatz (33) an dem zugekehrten Ende der Gewindeaufnahme (34) unverdrehbar einsetzbar sind, wobei die Muttern (31) mit einer Handhabe (35) versehen sind, die durch das fluchtende Loch (21, 20, 49, 45) der jeweils anderen Kantenseite (12, 11) ragt.

17. Rahmengestell nach Anspruch 16, dadurch gekennzeichnet, dass die Handhabe (35) an einer Sollbruchstelle (36) von der Mutter (31) abtrennbar ist.

18. Rahmengestell nach Anspruch 16 und 17, dadurch gekennzeichnet, dass die Mutter (32) ohne Handhabe (35) als Schiebemutter für einen Profilabschnitt mit T-förmiger Nut oder Aufnahme verwendet ist.

19. Rahmengestell nach einem der Ansprüche 1 bis 18, dadurch gekennzeichnet, dass die den Kantenseiten (11, 12) des Vierkantprofils (10) gegenüberliegenden Seiten (13, 14) mit zusätzlichen Bohrungen (23, 51) versehen sind. die mit den zugeordneten quadratischen oder rechteckförmigen Löchern (20, 21) der Kantenseiten (11, 12) fluchten.

20. Rahmengestell nach einem der Ansprüche 1 bis 19, dadurch gekennzeichnet, dass ein Profilschenkel der Rahmenschenkel (10.1 bis 10.12) am freien Ende einen zum Vierkantprofil (10) hin eingebogenen Endabschnitt (17.1 bis 17.12) aufweist, dass die die vertikalen Seiten des Rahmengestelles bildenden Rahmenschenkel (10.3, 10.5, 10.8, 10.11 und 10.4, 10.6, 10.7, 10.12) mit diesen Endabschnitten (17.3, 17.5, 17.8. 17.11 und 17.4, 17.6, 17.7, 17.12) der abgewinkelten Profilschenkel die Anlagestege zu Anlagerahmen erweitern, deren Anlageflächen parallel zu den vertikalen Seiten des Rahmengestelles verlaufen und dass die Endabschnitte (17.1 bis 17.12) der abgewinkelten Profilschenkel mit schlitzförmigen Ausnehmungen (24) versehen sind, die mit den Befestigungsbohrungen (23) der zugekehrten, parallelen Seiten (13) der Vierkantprofile (10) fluchten.

21. Rahmengestell nach einem der Ansprüche 1 bis 20, dadurch gekennzeichnet, dass die Beschlagteile, z.B. Scharniere (60), an der Befestigungsfläche mit einer Gegenverzahnung (64) versehen sind, die mit der Verzahnung an dem flachen Profilschenkel des Vierkantprofils (10) in Eingriff bringbar ist.

22. Rahmengestell nach einem der Ansprüche 1 bis 21, dadurch gekennzeichnet, dass die Rahmenschenkel (10.1 bis 10.12) von einem Strangpressprofil abgelängt sind.

23. Rahmengestell nach einem der Ansprüche 1 bis 21, dadurch gekennzeichnet, dass die Rahmenschenkel (10.1 bis 10.12) von einem Walzprofil abgelängt sind.

24. Rahmengestell nach Anspruch 23, dadurch gekennzeichnet, dass der flache Profilschenkel und der abgewinkelte Profilschenkel des Vierkantprofils (10) doppellagig ausgebildet sind und dass am flachen Profilschenkel die Verdickung durch einen auf die innere Lage (15) umgebogenen Endabschnitt (16) der aussenliegenden Lage gebildet ist, wobei am umgebogenen Endabschnitt (16) die Verzahnung mit den Zahnlücken (22) ausgestanzt ist.

25. Rahmengestell nach einem der Ansprüche 1 bis 24, dadurch gekennzeichnet, dass alle Ecken und Kanten des Vierkantprofils (10) abgerundet sind.

26. Rahmengestell nach einem der Ansprüche 1 bis 25, dadurch gekennzeichnet, dass die Abschlusswände (52) und die Türen (58) mit einem Stülprand (53, 59) versehen sind, der den rahmenartigen Dichtungssteg an der Vorder- oder Rückseite und den Anlagerahmen an den vertikalen Seiten des Rahmengestelles umschliesst und dass die Abschlusswände (52) und die Türen (58) im Bereich der Anlage zu dem Dichtungssteg und dem Anlagerahmen mit Dichtungselementen (70, 71, 72) versehen sind.

27. Rahmengestell nach einem der Ansprüche 1 bis 26, dadurch gekennzeichnet, dass der flache und der abgewinkelte Profilschenkel die zugeordneten Kantenseiten (11, 12) um dasselbe Mass verbreitern.

## Claims

1. A support frame for a switch cabinet, comprising at least twelve interconnected frame members of the same hollow profile, in which the hollow profile which is in the form of a tetragonal profile is provided with rows of holes and forms an edge with two edge sides which are disposed perpendicularly to each other, in which disposed on the hollow profile remote from the edge are two profile limb portions which are each oriented in parallel relationship with the associated edge side, and in which the edges of all frame members are arranged in the same manner relative to the interior of the support frame, characterised by the combination of features that :
   the edges (27.1 to 27.12) of all interconnected frame members (10.1 to 10. 12) are directed towards the interior of the support frame,
   the profile limb portions are extensions of the associated edge sides (11, 12),
   the edge sides (11, 12) are provided with identical rows of holes symmetrically with respect to the edge (27),
   the frame members (10. 1, 10. 5, 10. 6, 10. 9 and 10. 2, 10. 7, 10. 8 and 10. 10) forming the front side and the rear side of the support frame, with their projecting profile limb portions, form a frame-like sealing web which is disposed perpendicularly to the front and rear sides respectively, and
   the frame members (10.3, 10.5, 10.8, 10.11 and 10.4, 10.6, 10.7 and 10. 12) forming the vertical sides of the support frame, with their projecting profile limb portions, form a frame-like contact web which is disposed perpendicularly to the vertical sides.

2 A support frame according to claim 1 characterised in that the tetragonal profile (10) encloses a receiving means (28) which is of square cross-section.

3. A support frame according to claim 1 or claim 2, characterised in that holes (20, 21) of the rows of holes are provided in the edge sides (11, 12) in a square or rectangular configuration and at a unitary pitch.

4. A support frame according to claim 3, characterised in that bores (25, 26) are arranged between the square or rectangular holes (20, 21) of the rows of holes, displaced by half a pitch.

5. A support frame according to one of claims 1 to 4, characterised in that the holes (20, 21, 25, 26) of the rows of holes of all vertical frame members (10.5, 10.6, 10.7, 10.8) are arranged in the same horizontal planes, the holes (20, 21, 25, 26) of all horizontal frame members (10.1, 10.2, 10.9, 10.10) which extend parallel to the front and rear sides of the support frame are arranged in identical vertical planes extending parallel to the front and rear sides, and the holes (20, 21, 25, 26) of all horizontal frame members (10.3, 10.4, 10.11, 10.12) extending perpendicularly relative to the front and rear sides of the support frame are arranged in identical vertical planes extending perpendicularly to the front and rear sides.

6. A support frame according to one of claims 1 to 5, characterised in that the flat profile limb portion of the tetragonal profile (10), on the inward side which is towards the tetragonal profile (10), goes into a thickened end portion (16) by way of a step, and the step, towards the tetragonal profile (10), has a rectangular tooth configuration which is arranged at the pitch of the row of holes in the edge sides (11, 12) and in which the gaps (22) between the teeth are aligned with the square holes (20, 21) in the edge sides (11, 12) of the tetragonal profile (10).

7. A support frame according to one of claims 1 to 6, characterised in that the frame members (10.1 to 10.12) are welded together (29) at the corners.

8. A suppport frame according to one of claims 1 to 6, characterised in that the frame members (10.1 to 10.12) are connected together at the corners by means of corner connectors (30) which are introduced with projections into the receiving means (28) of the mutually butting frame members (for example 10.1, 10.3, 10.5).

9. A support frame according to claim 8. characterised in that the frame members (10.1 to 10.12) are screwed and/or welded at the corners to the corner connectors (30).

10. A support frame according to one of claims 1 to 9 characterised in that additional transverse struts (44) having at least two mutually perpendicular edge sides which are provided with identical rows of holes to the frame members (10.1 to 10.12) of the support frame interconnect mutually oppositely disposed horizontal or vertical frame members (10.1, 10.2 or 10.5, 10.8) of the support frame.

11. A support frame according to claim 10 characterised in that the transverse struts (44) have a square internal receiving means which corresponds to the receiving means (28) of the tetragonal profile (10) and

the internal receiving means is accessible by way of a through slot (48) in one side of the transverse strut (44).

12. A support frame according to claim 10 and claim 11, characterised in that a parallelipipedic nut (40) can be fitted into the internal receiving means in the transverse strut (44) and can be fixed by means of a headed screw (37) to a frame member (10.1 to 10.12) of the support frame.

13. A support frame according to claim 12, characterised in that the side walls of the nut (40) are provided with screwthreaded receiving means (43) and the ends are provided with square or rectangular projections (42) which are matched to the holes (20, 21) in the frame members (10.1 to 10.2), and one side of the transverse strut (44) is provided with fixing bores (47).

14. A support frame according to claim 12, characterised in that the head (38) of the headed screw (37) is of rectangular cross-section, wherein the smaller dimension corresponds to the dimension of the square holes (20, 21) in the frame members (10.1 to 10.12) of the support frame while the larger dimension is slightly larger and permits the head (38) to be introduced inclinedly into such a hole (20, 21).

15. A support frame according to one of claims 12 to 14, characterised in that the headed screw (13) is provided at the end of the screwthreaded portion with a tool receiving means (39) at its end face.

16. A support frame according to one of claims 1 to 15, characterised in that nuts (31) with a square or rectangular fitting projection (33) at the adjacent end of the screwthreaded receiving means (34) can be non-rotatbly fitted into the square or rectangular holes (20, 21, 45, 49) in the edge sides (11, 12) of the frame members (10.1 to 10.12) and the transverse struts (44), from the inward side, wherein the nuts (31) are provided with a handle means (35) which projects through the aligned hole (21, 20, 49, 45) of the respective other edge side (12, 11).

17. A support frame according to claim 16, characterised in that the handle means (35) can be separated from the nut (31) at a desired-rupture location (36).

18. A support frame according to claim 16 and claim 17, characterised in that the nut (32), without handle means (35), is used as a sliding nut for a profile portion with a T-shaped groove or receiving means.

19. A support frame according to one of claims 1 to 18, characterised in that the sides (13, 14) which are in opposite relationship to the edge sides (11, 12) of the tetragonal profile (10) are provided with additional bores (23, 51) which align with the associated square or rectangular holes (20, 21) in the edge sides (11, 12).

20. A support frame according to one of claims 1 to 19, characterised in that a profile limb portion of the frame members (10.1 to 10.12), at the free end, has an end portion (17.1 to 17.12) which is bent in towards the tetragonal profile (10), the frame members (10.3, 10.5, 10.8, 10.11 and 10.4, 10.6, 10.7 and 10.12) forming the vertical sides of the support frame, with said end portions (17.3, 17.5, 17.8, 17.11 and 17.4, 17.6, 17.7 and 17.12) of the angled profile limb portions, enlarge the contact webs to provide contact frames whose contact surfaces extend parallel to the vertical sides of the support frame, and the end portions (17.1 to 17.12) of the angled profile limb portions are provided with slot-shaped openings (24) which align with the fixing bores (23) of the facing parallel sides (13) of the tetragonal profiles (10).

21. A support frame according to one of claims 1 to 20, characterised in that the fitments, for example hinges (60), are provided at the fixing surface with a co-operating tooth configuration (64) which can be brought into engagement with the tooth configuration on the flat profile limb portion of the tetragonal profile (10).

22. A support frame according to one of claims 1 to 21, characterised in that the frame members (10.1 to 10.12) are cut to length from an extruded profile.

23. A support frame according to one of claims 1 to 21, characterised in that the frame members (10.1 to 10.12) are cut to length from a rolled profile.

24. A support frame according to claim 23, characterised in that the flat profile limb portion and the angled profile limb portion of the tetragonal profile (10) are of a double-layer structure and on the flat profile limb portion the thickening is formed by an end portion (16) of the outer layer, which is bent over on to the inner layer (15), wherein the tooth configuration with the gaps (22) between the teeth is stamped out on the bent-over end portion (16).

25. A support frame according to one of claims 1 to 24, characterised in that all corners and edges of the tetragonal profile (10) are rounded off.

26. A support frame according to one of claims 1 to 25, characterised in that the closure walls (52) and the doors (58) are provided with a turned edge (53, 59) which encloses the frame-like sealing web at the front or rear sides and the contact frame at the vertical sides of the support frame, and the closure walls (52) and the doors (58) are provided with sealing elements (70, 71, 72) in the region of the position of contact with the sealing web and the contact frame.

27. A support frame according to one of claims 1 to 26, characterised in that the flat and the angled profile limb portions increase the width of the associated edge sides (11, 12) by the same amount.

## Revendications

1. Bâti pour armoire de commande, constitué par au moins douze éléments de structure reliés entre eux et formés d'un même profilé creux, bâti dans lequel le profilé creux constitué par un profilé carré est muni de rangées de trous et forme une arête grâce à deux ailes d'arête disposées perpendiculairement l'une à l'autre, dans lequel à l'opposé de l'arête deux branches de profilé sont disposées sur le profilé creux, chacune de ces branches étant dirigée parallèlement à l'aile d'arête correspondante et dans lequel les arêtes de tous les éléments de structure sont disposées de la même façon par rapport à l'espace intérieur du bâti,

caractérisé en ce que les arêtes (27.1 à 17.12) de tous les éléments (10.1 à 10.12) de structure reliés ensemble sont dirigées vers l'espace intérieur du bâti,

en ce que les branches de profilé sont des prolongements des ailes (11, 12) d'arête correspondantes,

en ce que les ailes (11, 12) d'arête sont munies de rangées de trous identiques symétriques par rapport à l'arête (27),

en ce que les éléments (10.1, 10.5, 10.6, 10.9 et 10.2, 10.7, 10.8, 10.10) de structure constituant la face avant et la face arrière du bâti forment, grâce à leurs branches de profilé qui dépassent, une bordure d'étanchéité en forme de cadre, disposée perpendiculairement à la face avant ou à la face arrière du bâti,

et en ce que les éléments (10.3, 10.5, 10.8, 10.11 et 10.4, 10.6, 10.7, 10.12) de structure, constituant les côtés verticaux du bâti, forment avec leurs branches de profilé qui dépassent une bordure d'appui en forme de cadre disposée perpendiculairement aux côtés verticaux.

2. Bâti selon la revendication 1, caractérisé en ce que le profil carré (10) entoure une partie ou zone réceptrice (28) de forme carrée.

3. Bâti selon la revendication 1 ou 2, caractérisé en ce que les trous (20, 21) des rangées de trous des ailes (11, 12) d'arête sont de forme carrée ou rectangulaire et sont disposés avec un pas uniforme.

4. Bâti selon la revendication 3, caractérisé en ce que, entre ces trous (20, 21), carrés ou rectangulaires, des rangées de trous sont disposées des trous ronds (25, 26) percés avec un décalage d'un demi-pas.

5. Bâti selon l'une des revendications 1 à 4, caractérisé en ce que, les trous (20, 21, 25, 26) des rangées de trous de tous les éléments verticaux (10.5, 10.6, 10.7, 10.8) de structure sont disposés dans les mêmes plans horizontaux, en ce que les trous (20, 21, 25, 26) de tous les éléments horizontaux (10.1, 10.2, 10.9, 10.10) de structure, qui s'étendent parallèlement à la face avant et à la face arrière du bâti, sont disposés dans les mêmes plans verticaux qui s'étendent parallèlement à la face avant et à la face arrière et en ce que les trous (20, 21, 25, 26) de tous les éléments horizontaux (10.3, 10.4, 10.11, 10.12) de structure, qui s'étendent perpendiculairement à la face avant et à la face arrière du bâti, sont disposés dans les mêmes plans verticaux qui s'étendent perpendiculairement à la face avant et à la face arrière.

6. Bâti selon une des revendications 1 à 5, caractérisé en ce que, la branche plate du profilé carré (10) se prolonge, par l'intermédiaire d'un talon, par une partie d'extrémité (16) plus épaisse du côté intérieur en direction du profil carré (10), et en ce que le talon présente, en direction du profil carré (10), une denture rectangulaire disposée selon le pas de la rangée de trous des ailes (11, 12), les intervalles (22) entre les dents étant au même niveau que les trous carrés (21, 22) des ailes (11, 12) d'arête du profil carré (10).

7. Bâti selon une des revendications 1 à 6, caractérisé en ce que, les éléments (10.1 à 10.12) de structure sont soudés (29) ensemble aux coins du bâti.

8. Bâti selon une des revendications 1 à 6, caractérisé en ce que les éléments (10.1 à 10.12) de structure sont assemblés aux coins au moyen de pièces (30) de jonction de coin qui s'introduisent par des embouts dans les parties ou zones réceptrices (28) des éléments de structure qui se rejoignent (par exemple 10.1, 10.3. 10.5).

9. Bâti selon la revendication 8, caractérisé en ce que, les éléments (10.1 à 10.2) de structure sont reliés, par vissage et/ou soudage aux coins, aux pièces (30) de jonction de coin.

10. Bâti selon une des revendications 1 à 9, caractérisé en ce que, des entretoises (44) supplémentaires comportant au moins deux ailes d'arête mutuellement perpendiculaires, qui sont munies des mêmes rangées de trous que les éléments (10.1 à 10.12) de structure du bâti, relient ensemble des éléments (10.1, 10.2 ou 10.5, 10.8) horizontaux ou verticaux de structure se font face.

11. Bâti selon la revendication 10, caractérisé en ce que les entretoises (44) présentent une partie réceptrice intérieure carrée, qui correspond à la partie ou zone réceptrice (28) du profilé carré (10), et en ce que la partie réceptrice intérieure est accessible par une fente (48) qui traverse un côté de l'entretoise (44).

12. Bâti selon les revendications 10 et 11, caractérisé en ce que, dans la partie réceptrice intérieure de l'entretois (44), peut être enfilé un écrou parallélépipédique (40) qui peut être fixé, au moyen d'une vis (37) à tête, à un élément (10.1 à 10.12) de structure du bâti.

13. Bâti selon la revendication 12, caractérisé en ce que, les parois latérales de l'écrou (40) sont munies de taraudages (43) et en ce que les parties frontales sont munies de saillies (42) carrées ou rectangulaires qui sont adaptées aux trous (20, 21) des éléments (10.1 à 10.12) de structure, et en ce qu'un côté de l'entretoise (44) est percé de trous (47) de fixation.

14. Bâti selon la revendication 12, caractérisé en ce que, la tête (38) de la vis (37) présente une section rectangulaire, la plus petite dimension correspondant à la dimension des trous rectangulaires carrés (20, 21) des éléments (10.1 à 10.12) de structure du bâti, tandis que la plus grande dimension est légèrement supérieure et autorise une introduction oblique de la tête (38) dans un tel trou (20, 21).

15. Bâti selon une des revendications 12 à 14, caractérisé en ce que, la vis (37) à tête est munie à l'avant, à l'extrémité de la partie filetée, d'une cavité (39) frontale destinée à recevoir des outils.

16. Bâti selon une des revendications 1 à 15, caractérisé en ce que, dans les trous (20, 21, 45, 49) carrés ou rectangulaires des côtés (11, 12) d'arête des éléments (10.1 à 10.12) de structure et des entretoises (44), des écrous (31) comportant une partie en relief (33) enfilable, carrée ou rectangulaire, peuvent être mis en place de façon à ce qu'il ne leur soit plus possible de tourner sur l'extrémité, tournée de ce côté intérieur, du taraudage (34), les écrous (31) comportant un organe (35) de préhension, qui dépasse par le trou (21, 20, 49, 45), situé au même niveau, de l'autre aile (12, 11) d'arête.

17. Bâti selon la revendication 16, caractérisé en ce que, l'orange (35) de préhension peut être séparé de l'écrou (31), à l'emplacement (36) d'une ligne de rupture volontaire.

18. Bâti selon les revendications 16 et 17, caractérisé en ce que, l'écrou (32), dépourvu d'organe (35) de préhension, peut être utilisée comme écrou coulissant dans une partie de profilé comportant une gorge ou une partie réceptrice en forme de T.

19. Bati selon une des revendications 1 à 18, caractérisé en ce que, les côtes (13, 14) situés en face des ailes (11, 12) d'arête du profilé carré (10) sont percés de trous ronds (23, 51) supplémentaires, qui sont au même niveau que les trous carrés ou rectangulaires (20, 21) correspondants des ailes (11, 12) d'arête.

20. Bâti selon une des revendications 1 à 19, caractérisé en ce qu'une branche de profilé des éléments (10.1 à 10.12) de structure présente, à son extrémité libre, une partie d'extrémité (17.1 à 17.12) recourbée en direction du profilé carré (10), en ce que les éléments (10.3, 10.5, 10.8, 10.11 et 10.4, 10.6, 10.7, 10.12) de structure qui constituent les côtés verticaux du bâti agrandissent les bordures d'appui grâce à ces parties d'extrémité (17.3, 17.5, 17.8, 17.11 et 17.4, 17.6, 17.7, 17.12) des branches de profilé cardées, pour former des cadres d'appui dont les surfaces d'appui s'étendent parallèlement aux côtés verticaux du bâti, et en ce que les parties d'extrémité (17.1 à 17.12) sont munies d'évidements (24) en forme de fentes, qui se trouvent au niveau des trous (23) de fixation percés dans les côtés parallèles (13) du profilé carré (10), situés vers les évidements.

21. Bâti selon une des revendications 1 à 20, caractérisé en ce que, les ferrures, par exemple les charnières (60), sont munies sur leur surface de fixation d'une contre-denture (64) qui peut être mise en prise avec la denture de la branche plate du profilé carré (10).

22. Bâti selon une des revendications 1 à 21, caractérisé en ce que, les éléments (10.1 à 10.12) de structure consistent en des longueurs découpées dans un profilé fabriqué à la presse à filer.

23. Bâti selon une des revendications 1 à 21, caractérisé en ce que, les éléments (10.1 à 10.12) de structure consistent en des longueurs découpées dans un profilé fabriqué par laminage.

24. Bâti selon la revendication 23, caractérisé en ce que, la branche plate et la branche coudée du profilé carré (10) sont formées de deux couches et, en ce qui concerne la branche plate de profilé, la surépaisseur est formée par une partie d'extrémité (16) de la couche située à l'extérieur, repliée sur la couche intérieure (15), la denture comportant les intervalles (22) entre les dents étant découpée dans la partie d'extrémité (16) repliée.

25. Bâti selon une des revendications 1 à 24, caractérisé en ce que, tous les angles et arêtes du profilé carré (10) sont arrondis.

26. Bâti selon une des revendications 1 à 25, caractérisé en ce que, les parois (52) de fermeture et les portes (58) sont munies d'un bord (53, 59) de recouvrement qui entoure, sur les côtés verticaux du bâti, la bordure d'étanchéité en forme de cadre des faces avant et arrière et le cadre d'appui, et en ce que les parois (52) de fermeture et les portes (58) sont munies d'éléments (70, 71, 72) d'étanchéité dans la zone d'appui sur la bordure d'étanchéité et sur le cadre d'appui.

27. Bâti selon une des revendications 1 à 26, caractérisé en ce que, la branche de profilé plate et la branche de profilé coudée allongent dans une même mesure les ailes (11, 12) d'arête correspondantes.

Fig.1

Fig.2

Fig.3

Fig.4

Fig. 5

EP 0 144 955 B2

Fig.6

EP 0 144 955 B2

Fig.7

Fig.8

Fig.9

Fig.10

Fig.11

Fig.12

Fig.13

Fig. 14

EP 0 144 955 B2